# EUROPEAN PATENT APPLICATION

(11) **EP 2 506 331 A1**
(43) Date of publication of application: **03.10.2012**
(21) Application number: 12153893.8
(22) Date of filing: 03.02.2012
(51) Int. Cl.: H01L 51/52

(54) **Method of manufacturing a large area optoelectronic device using a master stamper**

(30) Priority: 31.03.2011 IN EL09092011 D
(71) Applicant: Moser Baer India Ltd., 110020 New Delhi (IN)
(72) Inventor: Peters, Patrick, 110020 New Dehli (IN); Titulaer, Bram, 110020 New Dehli (IN); De Ruijter, Jan, 110020 New Dehli (IN)
(74) Representative: Beck & Rössig European Patent Attorneys

(57) **Abstract**

A method of manufacturing an optoelectronic device (100a, 100b) is provided. The method includes providing a base substrate (104) having a substantially flat surface and depositing a lacquer on the base substrate (104) to form a lacquer layer. Following this, a master stamper formed by a plurality of adjoining small size stampers (208) is provided. The master stamper includes negative impressions (210) of light management structures, such that the light management structures are separated by one or more seam lines (304) corresponding to abutting edges of the plurality of adjoining small size stampers (208). The method also includes imprinting the light management structures (210) on the lacquer layer by pressing the master stamper against the lacquer layer. The imprinting of the light management structures 210 further causes imprinting of the one or more seam lines (304) on the lacquer layer. Thereafter, a transparent conducting oxide TCO layer (108, 122) is deposited on the lacquer layer and one or more functional lines (412, 414a, 414b) are applied on the TCO layer (108, 122), such that the one or more functional lines (412, 414a, 414b) substantially aligns with the one or more seam lines (304).

## Description

### FIELD OF INVENTION

The invention disclosed herein relates, in general, to optoelectronic devices. More specifically, the invention relates to a method of manufacturing high efficiency large area optoelectronic devices.

### BACKGROUND

In functioning of optoelectronic devices like an organic light emitting device (OLED) or a thin-film photovoltaic device (TF-PV), for example organic photovoltaic devices (OPV) or inorganic photovoltaic devices, light management is a very critical aspect that substantially affects the efficiency of such devices.

For example, efficiency of a TF-PV device is significantly determined by its ability to capture maximum amount of incident solar light for conversion into electrical energy. Therefore, in order to maximize the amount of incident solar light absorbed, the TF-PV device is provided with a light management texture to scatter the incident solar light within semiconductor layers. This scattering increases an optical path length of the incident solar light in the semiconductor layers leading to absorption of as much light as possible.

Similarly, in an OLED, efficiency is determined by an amount of light emitted by the OLED device. Generally, a refractive index of semiconductor layers is greater than a refractive index of a substrate in the OLED. Due to difference in refractive indices of substrate and organic layers in an OLED, a portion of emitted light gets reflected back from the substrate thereby reducing percentage of the emitted light that can be extracted. Also, due to a difference in the refractive indices of the substrate and an ambient medium, some light gets reflected back into the substrate at the interface between the substrate and the ambient medium. Thereby, further decreasing the efficiency of the OLEDs. To increase the efficiency of OLEDs, light management textures are added to the OLEDs at the interfaces between different refractive index materials. For example, the OLED may have a light management texture on a layer deposited between the organic layers and the substrate or between the substrate and the ambient medium. The presence of light management texture ensures an increase in light that can be extracted, thereby improving the efficiency of the OLEDs.

The application of light management textures into large area OLEDs and TF-PV devices has its own share of problems. Though, techniques capable of creating almost any arbitrarily shaped light management textures exist, for example, laser beam recording, E-beam lithography, projection lithography (wafer steppers), nano imprint lithography, holography etc; but these techniques can only be used over a small area and not over a large area device.

A commonly used technique, also described in an earlier application of the applicants, for application of the light management textures onto large area OLEDs and TF-PV devices include use of a large area master stamper. According to the technique, a large-area master stamper is developed by combining a plurality of small size stampers, and thereafter the large-area master stamper is pressed against a curable layer to imprint the light management textures into the curable layer. This provides the large-area master stamper with high precision in light management textures present in the small size stampers at a low cost. Also, optimized light management textures developed according to this technique provide a significantly higher efficiency that cannot be obtained using other techniques.

However, on combining the plurality of small size stampers to form the large-area master stamper, the master stamper is also left with seam lines corresponding to abutting edges of adjoining small size stampers. While imprinting the light management textures using the above technique, the seam lines also get imprinted into the curable layer. The seam lines cause a decrease in efficiency of the large area devices and also results in electronic problems.

Accordingly, in light of the above discussion, there is a need for a low cost method of manufacturing large area optoelectronic devices that have high efficiency, and eliminates one or more drawbacks of the prior art.

### BRIEF DESCRIPTION OF FIGURES

The features of the present invention, which are believed to be novel, are set forth with particularity in the appended claims. The invention may best be understood by reference to the following description, taken in conjunction with the accompanying drawings. These drawings and the associated description are provided to illustrate some embodiments of the invention, and not to limit the scope of the invention.
FIGs. 1a and 1b illustrate a stack of layers in an exemplary OLED and an exemplary TF-PV device, respectively, in accordance with an embodiment of the present invention;
FIGs. 2a, 2b, 2c and 2d illustrate a schematic view of different stages of formation of an exemplary small size stamper, in accordance with an embodiment of the present invention;
FIGs. 3a, and 3b illustrate a cross-sectional view and a top view of an exemplary stage during formation of an exemplary large-area master stamper, respectively, in accordance with an embodiment of the present invention;
FIGs. 4a and 4b illustrate a cross-sectional view of a TF-PV device before and after scribing, respectively, in accordance with an embodiment of the present invention;
FIGs. 5a and 5b illustrate a cross-sectional view of an OLED after application of electrically conducting gridlines, in accordance with two different embodiments of the present invention;
FIG. 6 is a flow chart describing an exemplary process of manufacturing an optoelectronic device, in accordance with an embodiment of the present invention;
FIG. 7 illustrates an exemplary light management structure, in accordance with an embodiment of the present invention;
FIG. 8 illustrates another exemplary light management structure, in accordance with an embodiment of the present invention; and
FIG. 9 illustrates yet another exemplary light management structure, in accordance with an embodiment of the present invention.

Those with ordinary skill in the art will appreciate that the elements in the figures are illustrated for simplicity and clarity and are not necessarily drawn to scale. For example, the dimensions of some of the elements in the figures may be exaggerated, relative to other elements, in order to improve the understanding of the present invention.

There may be additional structures described in the foregoing application that are not depicted on one of the described drawings. In the event such a structure is described, but not depicted in a drawing, the absence of such a drawing should not be considered as an omission of such design from the specification.

### SUMMARY

The present invention provides a method of manufacturing an optoelectronic device. The method includes providing a base substrate having a substantially flat surface and applying a lacquer on the base substrate to form a lacquer layer. Thereafter, a master stamper including a plurality of adjoining small size stampers is provided. The master stamper further includes negative impressions of light management structures separated by one or more seam lines, wherein the one or more seam lines correspond to abutting edges of the plurality of adjoining small size stampers. This step of using plurality of small size stampers to form a master stamper allows use of best possible mastering techniques to form optimized and efficient light management structures and replicating it over a large area.

Thereafter, the master stamper is pressed against the lacquer layer, thereby imprinting the light management structures in the lacquer layer. The imprinting of the light management structures also results in imprinting of the one or more seam lines in the lacquer layer. Thereafter, a transparent conducting layer (TCL), for example a transparent conducting oxide (TCO) layer is deposited on the lacquer layer and one or more functional lines are applied on the TCO layer, such that the one or more functional lines completely mask the one or more seam lines and prevent them from being seen. The one or more seam lines imprinted on the optoelectronic device have detrimental effects on both functional properties and cosmetic appearance of the optoelectronic device. The seam lines can interfere with functioning of the optoelectronic device by locally altering light management properties resulting in loss of efficiency and an increased risk of forming shunts or shorts. Further, in case of an OLED, the seam lines have an undesirable visible effect. Subsequently, one or more absorbing (in case of PV) or emitting layers (in case of OLED) are deposited on the TCO layer, a second electrical contact is deposited on the one or more absorbing or emitting layers and a cover substrate is provided.

In an embodiment, the present invention provides a method of manufacturing an optoelectronic device. The method includes providing a base substrate having a substantially flat surface. Thereafter, a lacquer is applied on the base substrate to form a lacquer layer. Following which a master stamper is provided. The master stamper is formed by a plurality of adjoining small size stampers, such that the master stamper has negative impressions of light management structures. The light management structures are separated by one or more seam lines, wherein the one or more seam lines correspond to abutting edges of the plurality of adjoining small size stampers. Subsequently, the light management structures are imprinted in the lacquer layer by pressing the master stamper in the lacquer layer. The imprinting of the light management structures further causes imprinting of the one or more seam lines on the lacquer layer. Thereafter, a transparent conducting layer (TCL)is deposited on the lacquer layer and one or more functional lines are applied in or on top of the TCL, such that the one or more functional lines substantially aligns with the one or more seam lines. Thereafter, one or more absorbing or emitting layers are deposited on the TCL, a second electrical contact is deposited on the one or more organic layers and a cover substrate is provided.

In some embodiments, the functional lines are one of a laser scribe, a mechanical scribe, optical scribe and an electrically conducting gridline when the optoelectronic device is a thin-film photovoltaic device (TF-PV).

In some embodiments, the functional lines are an electrically conducting gridline when the optoelectronic device is an organic light emitting device (OLED).

In some embodiments, the light management structures enable light trapping when the optoelectronic device is thin-film photovoltaic device (TF-PV).

In some embodiments, the light management structures enable light extraction when the optoelectronic device is an organic light emitting device (OLED).

In some embodiments, the method further includes curing the lacquer layer after imprinting the light management structures in the lacquer layer.

In some embodiments, the light management structures have at least one of a periodic and a quasi periodic shape.

In some embodiments, the step of imprinting including heating the lacquer layer to a temperature greater than a glass transition temperature of the lacquer layer, thereby softening the lacquer layer. This is followed by pressing the master stamper against the lacquer layer, thereby enabling replication of the light management structures into the lacquer layer; and finally cooling the lacquer layer.

### DESCRIPTION OF THE EXEMPLARY EMBODIMENTS

Before describing the present invention in detail, it should be observed that the present invention utilizes a combination of method steps and apparatus components related to a method of manufacturing a semiconductor device. Accordingly the apparatus components and the method steps have been represented where appropriate by conventional symbols in the drawings, showing only specific details that are pertinent for an understanding of the present invention so as not to obscure the disclosure with details that will be readily apparent to those with ordinary skill in the art having the benefit of the description herein.

While the specification concludes with the claims defining the features of the invention that are regarded as novel, it is believed that the invention will be better understood from a consideration of the following description in conjunction with the drawings, in which like reference numerals are carried forward.

As required, detailed embodiments of the present invention are disclosed herein; however, it is to be understood that the disclosed embodiments are merely exemplary of the invention, which can be embodied in various forms. Therefore, specific structural and functional details disclosed herein are not to be interpreted as limiting, but merely as a basis for the claims and as a representative basis for teaching one skilled in the art to variously employ the present invention in virtually any appropriately detailed structure. Further, the terms and phrases used herein are not intended to be limiting but rather to provide an understandable description of the invention.

The terms "a" or "an", as used herein, are defined as one or more than one. The term "another", as used herein, is defined as at least a second or more. The terms "including" and/or "having" as used herein, are defined as comprising (i.e. open transition). The term "coupled" or "operatively coupled" as used herein, is defined as connected, although not necessarily directly, and not necessarily mechanically.

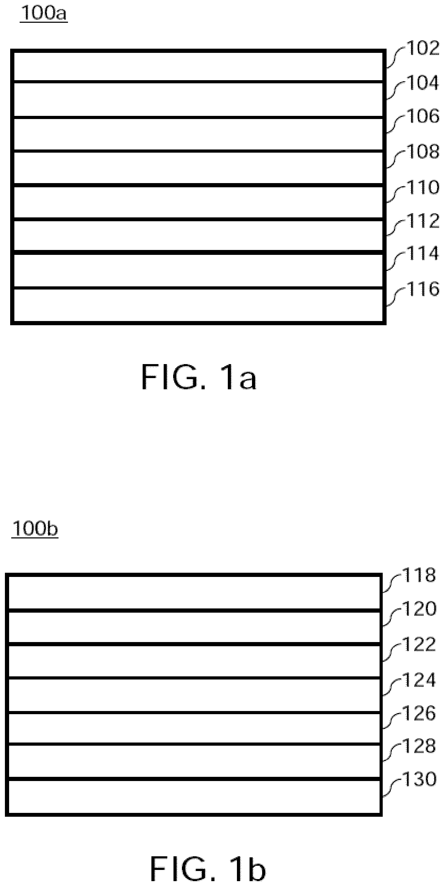

Referring now to the drawings, there is shown in FIG. 1a, a stack of layers in an exemplary OLED 100a, in accordance with an embodiment of the present invention. The OLED 100a is shown to include an external light extraction layer 102, a base substrate 104, an internal light extraction layer 106, a first electrical contact 108, one or more organic layers 110 and 112, a second electrical contact 114 and a cover substrate 116, which encapsulates the internal light extraction layer 106, the first electrode 108, the one or more organic layers 110 and 112 and the second electrode 114 between itself and the base substrate 104. Each layer of the OLED 100a, apart from the external light extraction layer 102 and the internal light extraction layer 106, can be coated or otherwise applied on the adjacent layer to implement the present invention.

For the purpose of the description, the OLED 100a has been shown to include only those layers that are pertinent to the description of the invention. However, it should be understood that the invention is not limited to the layers listed above. In some cases, the OLED 100a may include additional layers to enhance efficiency or to improve reliability, without deviating from the scope of the invention.

Some real life examples of the OLED 100a can include, but are not limited to, Organic Light Emitting Diode (OLED), White Organic Light Emitting Diode (W-OLED), Active-matrix Organic Light Emitting Diodes (AMOLED), Passive-matrix Organic Light Emitting Diodes (PMOLED), Flexible Organic Light Emitting Diodes (FOLED), Stacked Organic Light Emitting Diodes (SOLED), Tandem Organic Light Emitting Diode, Transparent Organic Light Emitting Diodes (TOLED), Top Emitting Organic Light Emitting Diode, Bottom Emitting Organic Light Emitting Diode, Fluorescence doped Organic Light Emitting Diode (F-OLED) and Phosphorescent Organic Light Emitting Diode (PHOLED).

The base substrate 104 provides strength to the OLED 100a, and also acts as an emissive surface of the OLED 100a when in use. The examples of the base substrate 104 include, but are not limited to, glass, flexible glass, polyethylene terephthalate (PET), polyethylene naphthalate (PEN), and other transparent or translucent material.

The first electrical contact 108 and the second electrical contact 114 are used to apply a voltage across the one or more organic layers 110 and 112. The first electrical contact 108 and can be implemented with a transparent conductive layer (TCL), for example, a transparent conductive oxide (TCO). TCOs are doped metal oxides, examples of TCOs include, but are not limited to, Aluminum-doped Zinc Oxide (AZO), Indium Zinc Oxide (IZO), Boron doped Zinc Oxide (BZO), Gallium doped Zinc Oxide (GZO), Fluorine doped Tin Oxide (FTO) and Indium doped Tin Oxide (ITO). Further, the second electrical contact 114 can be implemented with metals with appropriate work function to make injection of charge carriers, for example, calcium, aluminum, gold, and silver.

The one or more organic layers 110 and 112 can be implemented with any organic electroluminescent material such as a light-emitting polymer, evaporated small molecule materials, light-emitting dendrimers or molecularly doped polymers.

In an OLED light emitted by the one or more organic layers 112 and 114 needs to pass through the base substrate 104. However, when light is incident from a high refractive index material onto an interface with a lower refractive index material or medium, the light undergoes total internal reflection (TIR) for all incidence angles greater than the critical angle θ_{c}, defined by θ_{c} = sin⁻¹ (n₂/n₁), where n₁ and n₂ are the refractive indices of the high refractive index material and low refractive index material, respectively. Due to the same reason, when the light emitted by the semiconductor layer 110 or 112 reaches their interface with the base substrate 104, a substantial amount of light is reflected back into the organic layers 110 and 112.

Presence of an internal light extraction layer 106 having light management structures that are capable of changing the propagation direction of the light emitted by the one or more semiconductor layer 110 or 112 at their interface with the base substrate 104 helps to reduce the reflection (or TIR) of the light back into the OLED 100a. The light management structures on the internal light extraction layer 106 may include geometries having dimensions in the order of the wavelength of the light to facilitate the change in propagation direction of the emitted light by diffraction. The light management structures on the internal light extraction layer 106 may also include geometries having larger dimensions than the wavelength of the light to facilitate the change in propagation direction of the emitted light by refraction. Therefore, presence of an internal light extraction layer 106 having light management structures to act as the absorbing and the scattering entities which eliminates or reduces the TIR, further increases the efficiency of the OLED 100a. In a similar manner, the external light extraction layer 102 reduces or eliminates the TIR at an interface between the transparent substrate 104 and an ambient medium.

Referring now to FIG. 1b, there is shown a stack of layers in an exemplary TF-PV device 100b, in accordance with an embodiment of the present invention. The TF-PV device 100b is shown to include a base substrate 118, a light trapping layer 120, a first electrical contact 122, one or more absorbing layers 124 and 126, a second electrical contact 128 and a cover substrate 130.

In the TF-PV device 100b, the light falling on the one or more absorbing layers 124 and 126 enable generation of electricity through the absorbing layers 124 and 126, which is extracted into external circuits by the first and second electrical contacts 122 and 128. In the TF-PV device 100b, the light trapping layer 120 including light management structures is provided to increase an optical path of the light transmitted in to the TF-PV device 100b. Examples of a material used as the one or more absorber layers 124 and 126 in the TF-PV device 100b include organic and inorganic semiconductor material.

The light management structures as described above enable light extraction and light trapping in cases of an OLED and a TF-PV device respectively. The light management structures are usually sub-micron sized micro-textures that are preferably one of periodic and quasi-periodic in nature. The light management structures are usually formed in optoelectronic device like an OLED or a TF-PV by a replication process. According to which a stamper having a micro-textured surface can be pressed into a lacquer layer deposited onto the substrate of the OLED or the TF-PV device, thereby imprinting the micro-texture into the lacquer layer.

For example, in an embodiment a lacquer layer of a viscous UV-curable material, such as a photo-polymer lacquer or a sol-gel material can be applied onto the substrate of the OLED or the TF-PV device. Thereafter, a stamper having a micro-textured surface can be pressed into thin layer of the viscous UV-curable material imprinting the micro-texture on the thin layer of the viscous UV-curable material, followed by application of a UV- curing process to affix the micro-texture on the surface of the substrate of the OLED or the TF-PV device.

In another embodiment, a lacquer layer of a viscous thermally curable material, such as a photo-polymer lacquer or a sol-gel material can be applied onto a substrate of the OLED or the TF-PV device. Thereafter a stamper having a micro-textured surface can be pressed into thin layer of the viscous thermally curable material imprinting the micro-texture on the thin layer of the viscous thermally curable material, followed by application of heat to affix the micro-texture on the surface of the substrate of the OLED or the TF-PV device.

In yet another embodiment, a stamper having a micro-textured surface can be pressed into a substrate of the OLED or the TF-PV device imprinting the micro-texture on the substrate of the OLED or the TF-PV device, while the substrate is being heated above its deformation (glass transition) temperature. This step can be followed by a rapid cooling process.

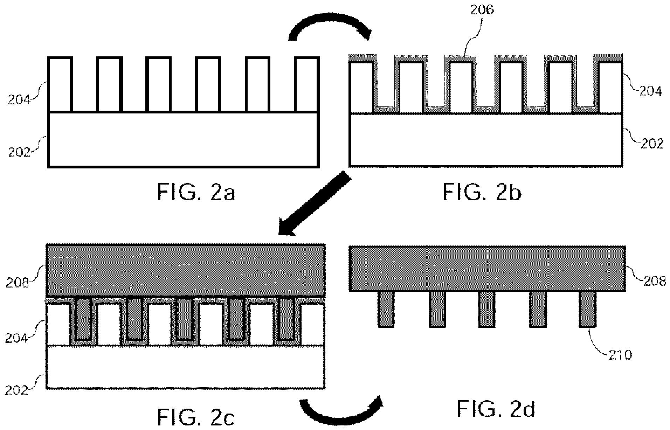

As can be seen from above, in order to produce the light management structure a stamper needs to be formed. FIGs. 2a, 2b, 2c and 2d illustrate a schematic view of different stages of formation of an exemplary small size stamper 208, in accordance with an embodiment of the present invention.

Referring to FIG. 2a there is shown a father stamper 202 carrying impressions 204 of the light management structures. The father stamper 202 usually includes a substrate having a photo-resist layer applied on top of the glass substrate. Examples of the substrate of the father stamper include, but are not limited to, a glass plate, a semiconductor wafer and a flat metal plate. Examples of the photo-resist layer can be any phase-transition material like novolac.

In an embodiment, a photo-lithographic process or thermo-lithographic process is carried out on the photo-resist layer to form the impressions 204 of the light management structures. However, it should be appreciated that the impressions 204 of the light management structures, can also be formed using processes like laser beam recording, E-beam lithography, projection lithography, nano-imprint lithography, and laser interference lithography. Though the method has been described in relation to photo-lithographic process, it is not intended to be limiting but rather to provide an understandable description of the invention.

During the process the photo-resist layer is locally illuminated by using a focused sub-micron-sized laser spot. The laser spot can be scanned over the photo-resist layer, either by moving the substrate under a stationary spot, or by moving the spot over a stationary substrate, or by a combination of both. In real life applications, a rotating substrate in combination with a linearly moving laser spot in the radial direction is used. In another embodiment, an x, y-stage may be used to move either the substrate or the laser spot in the lateral direction. In case of laser interference lithography no movement is needed as full surface of the photo resist layer is illuminated at once by using the interference pattern of two laser beams.

Thereafter, once the photo-resist layer has been illuminated, the photo-resist layer is processed, by exposing it to an etchant such as a diluted acid or base solution. Depending on the type of the photo-resist layer and the etchant used, the illuminated part of the photo-resist layer will exhibit either a higher or lower etching rate than its non- illuminated counterpart, resulting in the formation of the impressions 204 of the light management structures on the surface of the photo-resist layer.

The details of the impressions 204 of the light management structures are not only determined by the illumination process, as described above, but can also be manipulated by the process parameters of the development process, such as type of etchant, concentration of the etchant, development time and reflow by heat.

The light intensity of the laser spot can be modulated, so that illumination level of the photo-resist layer can be varied as a function of time and/or position. This allows formation of a variety of feature and shapes as the impressions 204 of the light management structures. For example, continuous intensity of the laser spot combined with a constant linear movement of the substrate will result in line-shaped features, whereas a pulse-modulated laser spot will result in dot- or dash-shaped features.

Further, height of the impressions 204 of the light management structures can be controlled by controlling thickness of the photo-resist layer as well as the illumination level of the photo-resist layer. Lateral size features of the impressions 204 of the light management structures, are determined by a variety of parameters, including wavelength of the laser, numerical aperture of a lens being used to focus the laser, intensity level of the light, duration of the laser's pulse and relative speed between the laser spot and the substrate. Usually, features that can be produced using the focused laser spot have dimensions in the order of the wavelength of the light being used.

Thereafter development of the father stamper 202 with the impressions 204 of the light management structures, the father stamper 202 is duplicated to form a plurality of the small size stamper 208.

In an embodiment, the father stamper 202 can be duplicated by using an electroplating process. However, it should be appreciated that other methods are also possible. Moving on to FIG. 2b, in the electro-plating process the father stamper 202 is sputtered with a metal layer, typically a nickel-alloy or a silver-alloy, to form a conducting electrode and a seed layer 206 for plating process.

Subsequently moving on to FIG. 2c, a small size stamper 208 is grown on top of the seed layer 206. The small size stamper 208 is typically metallic, like nickel or silver. The small size stamper 208 is subsequently removed from the father stamper 202, and contains a negative impression 210 of the light management structures on its surface, as can be seen in FIG. 2d. For example, the negative impressions 210 can be explained in light of FIGs. 2b and 2d. The negative impressions 210 are a negative impression of the impressions 204 of the light management structures and vice versa. As can be seen, the impressions 210 and 204 are alternately placed and will form a design similar to the other on being pressed against a lacquer layer. For example, if a conical shape is desired in the functional light structures to be formed on the base substrate of the organic optoelectronic device, then a corresponding hollow cone will be provided as the negative impressions on a stamper being used for the process of imprinting.

This duplication process of the father stamper 202 can be repeated several times, resulting in a family of the small size stampers 208 having the negative impression 210 of the light management structures. Further, the method of manufacturing the small size stamper 208 described above is such that it makes independent optimization of the light management structures for maximizing light extraction and light trapping possible.

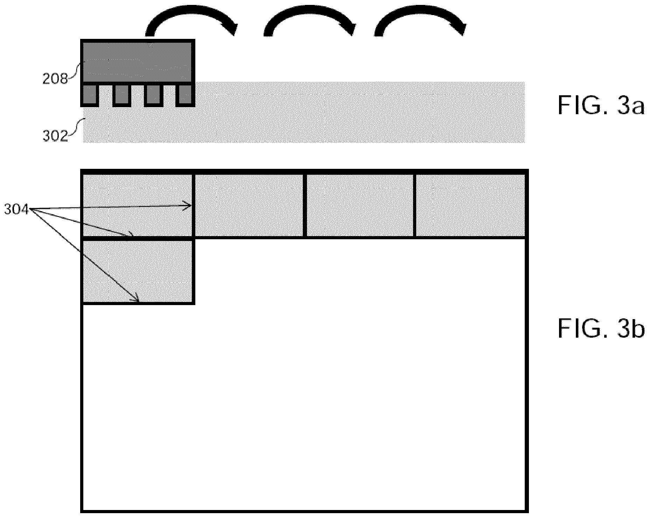

Moving on to FIGs. 3a and 3b, there is illustrated a cross-sectional view and a top view of an exemplary stage during formation of an exemplary large-area master stamper, respectively, in accordance with an embodiment of the present invention The small size stamper formed above can be used to form the master stamper. The small size stamper 208 or a plurality of the small size stampers 208 can be arranged adjoined to each other and used to form impressions of the light management structures on a large area photo-resist layer 302 as has been shown in FIGs. 3a and 3b.

Thereafter, the master stamper may be formed by carrying out an electroplating process similar to one described in conjunction with FIGs. 2b, 2c and 2d. Subsequently, after the electroplating process the master stamper having negative impressions of the light management structures is obtained. The master stamper has the advantage of having a large area and at the same time having highly optimized and efficient designs of the light management structures present in the small size stamper. In an embodiment, a size of the large area master stamper is equal to a size of the optoelectronic device being manufactured. The electro-plating process used is very accurate up to dimensions on sub-micron size scale and also allows easy and inexpensive scale up to large area surfaces like the master stamper.

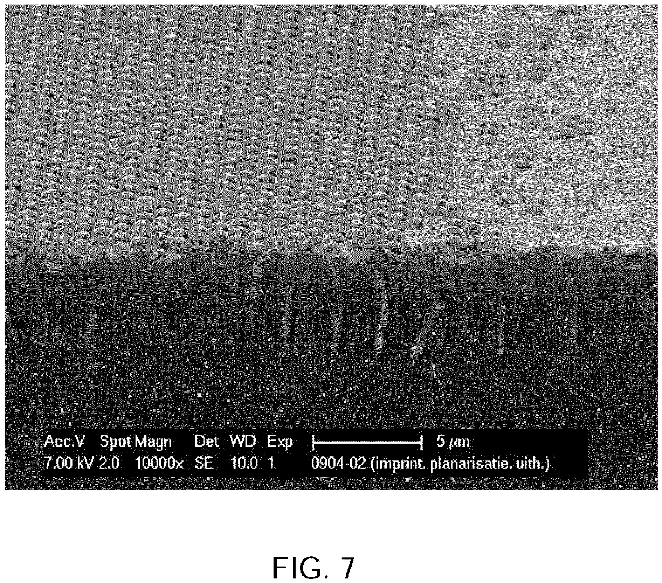

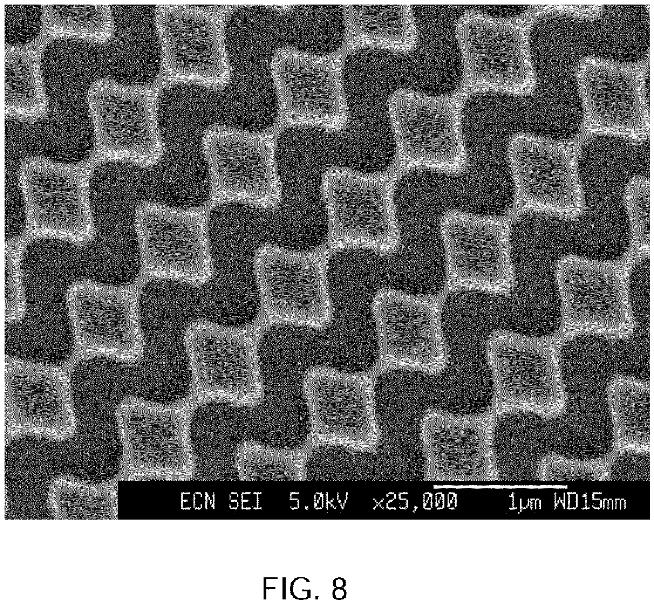

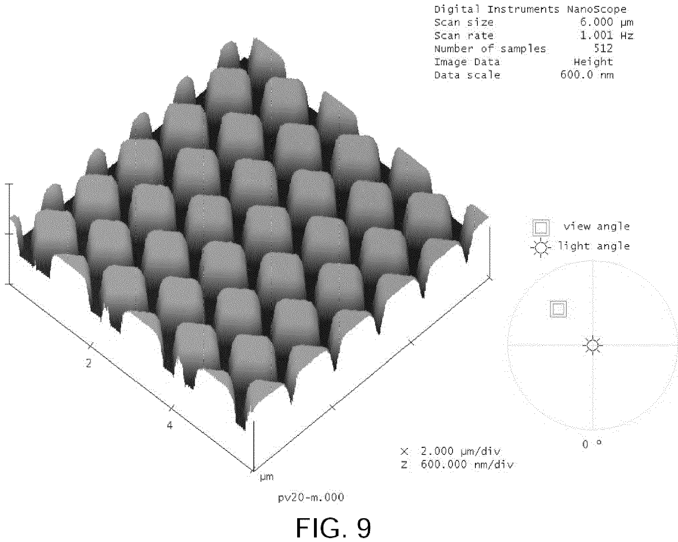

Another benefit provided by the master stamper of the present invention, is that it can produce the light management structures having dimensions in the sub-micron region on a substrate surface. Further, the light management structures' features can be precisely optimized and controlled. Also, lateral dimensions and depth of the light management structures' features can be optimized independently. The light management structures are periodic or quasi-periodic structures with a controlled and precise distance at sub-micron level. For example periodic poles (cylinders) with a diameter of 300 nm positioned at a distance 300 nm of each other in aligned arrays. Also, additional randomization is possible by either modulation of the laser intensity or of the laser spot position. Exemplary structures of the light management structures can be seen in FIGs. 7, 8 and 9.

However, the master stamper besides including the negative impressions of the light management structures, also include one or more seam lines 304. The one or more seam lines 304 correspond to abutting edges of the plurality of adjoining small size stampers used to form the master stamper. Therefore, while imprinting the light management structures on the lacquer layer, for example, by pressing the master stamper on the lacquer layer, the one or more seam lines 304 are also imprinted on the lacquer layer along with the light management structures.

Presence of the one or more seam lines 304 on the lacquer layer often results in reduction of light management properties at regions of the one or more seam lines 304. Further, the one or more seam lines 304 also cause formation of local hot spots and increase the risk of shunting. Further, the one or more seam lines 304 can also lead to a loss in efficiency.

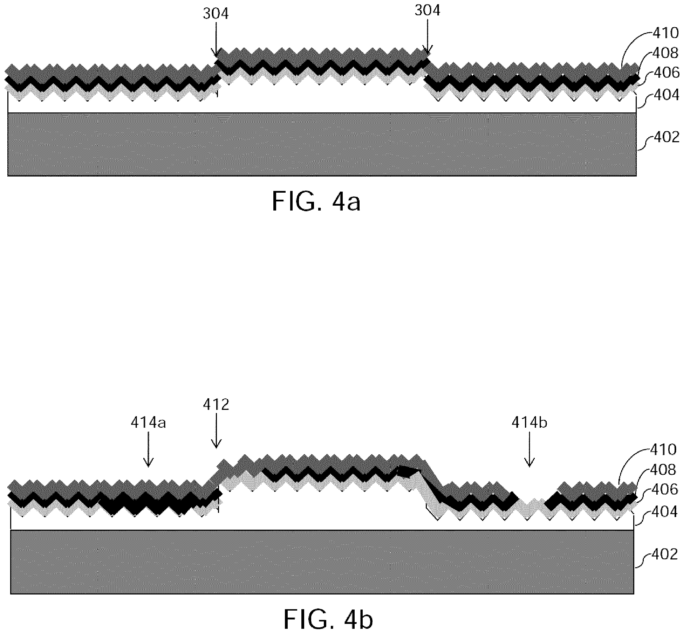

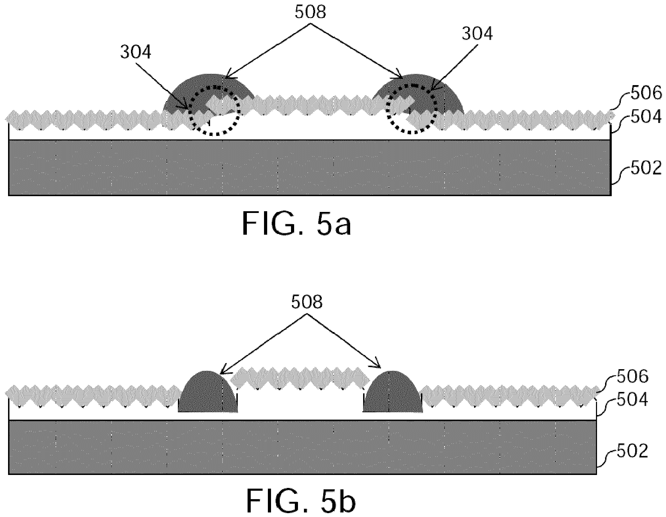

Therefore, in order to overcome problems associated with formation of the one or more seam lines 304, the present invention provides for application of one or more functional lines over the one or more seam lines. The one or more functional lines are applied such that they substantially completely align with the one or more seam lines 304, thereby masking the one or more seam lines 304 substantially completely. This concept of aligning the one or more functional lines with the one or more seam lines 304 has been explained in greater detail in conjunction with FIGs. 4 and 5.

There is shown in FIGs. 4a and 4b an illustration of a cross-sectional view of an exemplary TF-PV device without and with a laser scribed interconnect, respectively, in accordance with an embodiment of the present invention. The TF-PV device in FIG. 4a is shown to include a substrate 402, a light trapping layer 404, a first electrical contact 406, an absorber layer 408 and a second electrical contact 410. For the purpose of the description, the TF-PV device has been shown to include only those layers that are pertinent to the description of the invention. However, it should be understood that the invention is not limited to the layers listed above. Further, the TF-PV device in FIG. 4a is also shown to include the one or more seam lines 304.

In an embodiment, according to the invention the one or more functional lines can be one of a mechanical scribe, a laser scribe, an optical scribe and a conducting grid line, in case the optoelectronic device is a TF-PV device. As shown in FIG. 4b, at regions corresponding to the one or more seam lines 304, a scribing operation has been performed as a first scribe 414a, a second scribe 412 and a third scribe 414b can be seen. The first scribe 414a is known in the art as a P1 scribe, the first scribe 414a interrupts the first electrical contact 406. The second scribe 412 is known in the art as a P2 scribe, the second scribe 412 interrupts the absorber layer 408, and hence connects the first electrical contact 406 to the second electrical contact 410. The third scribe 414b is known in the art as a P3 scribe, and the third scribe 414b interrupts the absorber layer 408 and the second electrical contact 410. A combination of the scribes 414a, 412 and 414b constitutes an electrical interconnect of two adjoining photovoltaic unit cells. The second scribe 412 substantially completely aligns with the one or more seam lines 304. The area between the scribes 414a and 414b does not contribute to electricity generation in the TF-PV device and is therefore known as a dead area. By aligning one or more seam lines in the area between scribes 414a and 414b, loss of light trapping effect caused by the one or more seam lines 304 does not affect the efficiency of the TF-PV device as it is located in the dead area of the TF-PV device.

This provides a solution for any negative effect the seam line 304 has on the light trapping properties of the light trapping layer 404. Furthermore, a second disadvantage of having seam lines in a photovoltaic device is the risk of shunts. In principle, a shunt is a connection between the first electrical contact 406 and the second electrical contact 410. The shunt prevents a photovoltaic cell from generating energy when located in an active (electricity generating area) of the photovoltaic cell. When connecting two adjoining cells by an interconnect, for example the combination of the scribes 414a, 412 and 414b, a connection between the first electrical contact 406 and the second electrical contact 410 is necessary. This is achieved by applying a P2 scribe 412. Further, when a shunt is located between the scribes 414a and 414b it has the same function as the second scribe 412. Hence, by aligning the one or more seam lines 304 in such a manner that it is located between the scribes 414a and 414b the negative effect of a shunt is eliminated.

In this embodiment, the one or more functional lines 412, 414a and 414b have been defined in terms of the first scribe 414a, the second scribe 412 and the third scribe 414b and only two seam lines 304 have been shown. However, it will be readily apparent to those ordinarily skilled in the art that the number of seam lines and the functional lines can be greater or lesser than those illustrated in the figures. Further the exemplary scenario used for description purposes here is not intended to be limiting but rather to provide an understandable description of the invention.

Moving on, there is shown in FIGs. 5a an illustration of a cross-sectional view of an exemplary OLED after application of electrically conducting gridlines, in accordance with an embodiment of the present invention. The OLED in FIG. 5a is shown to include a substrate 502, a light extraction layer 504, a first electrical contact 506, and one or more functional lines 508. For the purpose of the description, the OLED has been shown to include only those layers that are pertinent to the description of the invention. However, it should be understood that the invention is not limited to the layers listed above. In an embodiment, according to the invention the one or more functional lines 508 can be the electrically conducting gridlines 508. The electrically conducting gridlines 508 conventionally consist of a printed metal (for example silver) having a thickness of 5 to 25 microns or conducting polymers (for example PEDOT:PSS) and serve a purpose of providing sufficient current flow to light emitting layers. As shown in FIG. 5a, at regions corresponding to the one or more seam lines 304, the electrically conducting gridlines have been deposited. The electrically conducting gridlines substantially completely aligns with the one or more seam lines 304. This ensures better usage of area covered by the electrically conducting gridlines. Also, there is no additional loss of light extraction feature due to the one or more seam lines 304. Further, shunting and formation of local hot spots is reduced, leading to an increase in efficiency. In addition, the OLED now provides visibly a more pleasant look from an aesthetic perspective.

Though, in this description, aligning the one or more functional lines with the one or more seam lines has been described with respect to an internal light extraction layer, it should be understood that in an embodiment, the invention can also be used similarly with an external light extraction layer. However, in case of an external light extraction layer, alignment of the one or more functional lines with the one or more seam lines is primarily to provide a pleasant look from an aesthetic perspective.

FIG. 5b is an illustration of another method in which the electrically conducting gridlines 508 may be placed to align with the one or more seam lines 304. In another embodiment, the electrically conducting gridlines 508 may be applied over a planarization layer placed over the light extraction layer 504.

In this embodiment, the one or more functional lines 508 have been defined in terms of the electrically conducting gridlines 508 and only two seam lines 304 have been shown. However, it will be readily apparent to those ordinarily skilled in the art that the number of seam lines and the functional lines can be greater or lesser than those illustrated in the figures. Further the exemplary scenario used for description purposes here is not intended to be limiting but rather to provide an understandable description of the invention.

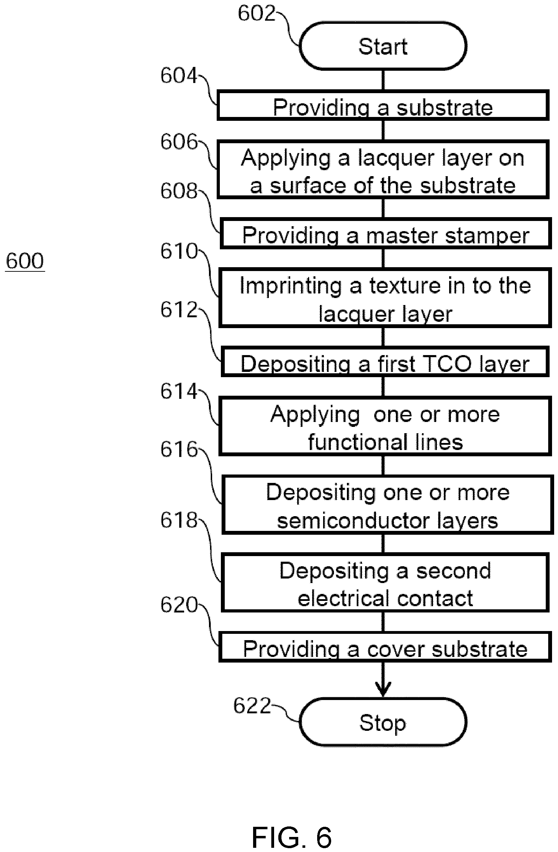

Moving on to FIG. 6, there is shown a flowchart depicting a method 600 of manufacturing an optoelectronic device, for example the OLED 100a, in accordance with an embodiment of the present invention. To describe the method 600, reference will be made to FIGs. 1, 2, 3, 4 and 5, although it is understood that the method 600 can be implemented to manufacture any other suitable device. Moreover, the invention is not limited to the order of in which the steps are listed in the method 600. In addition, the method 600 can contain a greater or fewer numbers of steps than those shown in FIG. 6.

Further, for the purpose of description, the method 600 has been explained in reference to an OLED and light extraction, however, it will be readily apparent to those ordinarily skilled in the art that the present invention can be implemented in a TF-PV device as well for light management purposes, like, light trapping.

The method 600 is initiated at step 602. At step 604, a substrate, for example the base substrate 104, having a substantially flat surface is provided.

Thereafter, at step 606 a lacquer is applied on the substrate 104 to form a lacquer layer. Examples of the lacquer material can include, but is not limited to, a ultra-violet curable material, a photo-polymer lacquer, an acrylate, and silica or silica-titania based sol-gel materials, and any other material having similar properties. Further, the lacquer can be deposited by using a brush or roller, dispensing, slot dye coating, spin-coating, spray coating, or printing.

Thereafter, at step 608 a master stamper is provided. The master stamper can be a stamper like the one described in conjunction with FIGs. 2 and 3 above. The master stamper includes the negative image of the light management structures on its surface. The master stamper containing the negative image of the light management structures can be used for imprinting the light management structures onto the lacquer layer on the base substrate 104 at step 610 by pressing the master stamper against the lacquer layer. The base substrate 104 is provided with the light management structures, for example a light extraction texture, thereby forming the internal light extraction layer 106. In addition to the light extraction texture, the one or more seam lines present on the master stamper are also imprinted on the lacquer layer.

Several methods of imprinting are possible, in an embodiment a UV- curable lacquer, such as a photo-polymer lacquer or a sol-gel material can be applied onto the substrate 104. Thereafter, the master stamper can be pressed into the lacquer layer imprinting the light management texture on the lacquer layer, followed by application of a UV- curing process to freeze the light management texture on the surface of the substrate 104.

In another embodiment, a thermally curable lacquer, such as a photo-polymer lacquer or a sol-gel material can be applied onto the substrate 104. Thereafter the master stamper can be pressed into the lacquer layer imprinting the light management structures on the lacquer layer, followed by application of heat to freeze the light management structures on the surface of the substrate 104.

In yet another embodiment, the step of imprinting includes heating the lacquer layer to a temperature greater than a glass transition temperature of the lacquer layer, thereby softening the lacquer layer. This is followed by pressing the master stamper against the lacquer layer, thereby enabling replication of the light management structures onto the lacquer layer and finally cooling the lacquer layer.

The method 600 allows formation of periodic or quasi-periodic light management structures with a controlled and precise distance at micron or sub-micron level on the substrate 104, thereby allowing maximization of light management efficiency of the optoelectronic device.

Subsequently, at step 612, a TCO layer, for example the first electrical contact 108 is deposited with conventional known methods on the internal light extraction layer 106. The first electrical contact 108 deposited. The first electrical contact 108 can be deposited by using various methods, such as dip coating, spin coating, doctored blade, spray coating, screen printing, sputtering, glass mastering, photoresist mastering, electroforming, and evaporation. In an embodiment, the first electrical contact 108 acts as an anode.

Thereafter, at step 614, one or more functional lines, for example the electrically conducting gridlines are applied. The electrically conducting gridlines are applied such that they align with the one or more seam lines imprinted on the lacquer layer 106 during step 610.

Thereafter, at step 616, one or more organic layers, for example the one or more organic layers 110 and 112 are deposited on the first electrical contact 108. The one or more organic layers 110 and 112 can be deposited by using various methods, such as dip coating, spin coating, doctored blade, spray coating, screen printing, sputtering, glass mastering, photoresist mastering, all kinds of CVD, electroforming, and evaporation.

Thereafter, at steps 618 and 620 a second electrical contact and a cover substrate are applied using conventional methods. Following which the method 600 is terminated at step 622.

Various embodiments, as described above, provide a method of manufacturing an optoelectronic device like an OLED or a TF-PV device that has several advantages. Since the method allows use of a master stamper that is formed using small size stampers, best possible techniques to form optimized and efficient light management structures can be used and replicated over a large area. This would not have been possible in case the small size stampers had not been used to form a large size master stamper.

Also, the one or more seam lines formed because of use of the master stamper are prevented from causing any detrimental effects on both functional properties and cosmetic appearance of the optoelectronic device. The functional lines in the optoelectronic device are applied such that they align with the one or more seam lines and prevent the detrimental effects that may have been caused by the one or more seam lines.

While the invention has been disclosed in connection with the preferred embodiments shown and described in detail, various modifications and improvements thereon will become readily apparent to those ordinarily skilled in the art. Accordingly, the spirit and scope of the present invention is not to be limited by the foregoing examples, but is to be understood in the broadest sense allowable by law.

All documents referenced herein are hereby incorporated by reference.

## Claims

1. A method of manufacturing an optoelectronic device (100a, 100b), said method comprising:
providing a base substrate (104,118) having a substantially flat surface;
applying a lacquer on said base substrate (104, 118) to form a lacquer layer;
providing a master stamper comprising a plurality of adjoining small size stampers (208), said master stamper having negative impressions of light management structures (210) separated by a one or more seam lines (304), said one or more seam lines (304) corresponding to abutting edges of said plurality of adjoining small size stampers (208);
imprinting said light management structures (210) on said lacquer layer by pressing said master stamper on said lacquer layer, wherein imprinting said light management structures (210) further causes imprinting of said one or more seam lines (304) on said lacquer layer;
depositing a transparent conducting layer (TCL) (108, 122) on said lacquer layer;
applying one or more functional lines (412, 414a and 414b) on said TCL (108, 122);
depositing one or more organic / absorber layers (110, 112, 124, 126) on said TCL (108, 122);
depositing a second electrical contact (114, 128) on said one or more organic / absorber layers (110, 112, 124, 126); and
providing a cover substrate (116, 130) on said second electrical contact (114, 128);
**characterized in that**
said one or more functional lines (412, 414a and 414b) substantially aligns with said one or more seam lines (304).

2. The method according to claim 1 further comprising curing said lacquer layer after imprinting said light management structures (210) on said lacquer layer.

3. The method according to claim 1 or 2, wherein said imprinting comprises:
heating said lacquer layer to a temperature greater than a glass transition temperature of said lacquer layer, thereby softening said lacquer layer;
pressing said master stamper against said lacquer layer, thereby enabling replication of said light management structures (210) onto said lacquer layer; and
cooling said lacquer layer.

4. The method according to one of claims 1 to 3, wherein said functional lines (412, 414a and 414b) are one of a laser scribe, a mechanical scribe and an optical scribe when said optoelectronic device (100b) is a thin film photovoltaic device (TF-PV).

5. The method according to one of claims 1 to 4, wherein said functional lines (412, 414a and 414b) are an electrically conducting gridline when said optoelectronic device (100a) is an organic light emitting device (OLED).

6. The method according to one of claims 1 to 5, wherein said light management structures (210) enable light trapping when said optoelectronic device (100b) is a thin film photovoltaic device (TF-PV).

7. The method according to one of claims 1 to 6, wherein said light management structures (210) enable light extraction when said optoelectronic device (100b) is an organic light emitting device (OLED).

8. The method according to one of claims 1 to 7, wherein said light management structures (210) have at least one of a periodic and a quasi periodic shape.
